# EUROPEAN PATENT SPECIFICATION

(11) **EP 3 943 461 B1**
(45) Date of publication and mention of the grant of the patent: **02.09.2026**
(21) Application number: 21196680.9
(22) Date of filing: 26.07.2018
(51) Int. Cl.: C03C 17/00, C03C 17/30, C03C 17/34, G02B 1/11, G02B 1/18, G02B 1/115

(54) **MULTI-LAYER ANTIREFLECTIVE COATED ARTICLES**
MEHRSCHICHTIGE, ANTIREFLEXBESCHICHTETE ARTIKEL
ARTICLES REVÊTUS D'UN REVÊTEMENT ANTIREFLET MULTICOUCHES

(30) Priority: 28.07.2017 US 201715662894
(43) Date of publication of application: 26.01.2022
(62) Document number(s) of the earlier application(s) in accordance with Art. 76 EPC: 18752980.5 / 3 658 517
(73) Proprietor: PPG Industries Ohio, Inc., Cleveland, OH 44111 (US)
(72) Inventor: LU, Songwei, Wexford, Pennsylvania 15090 (US); SHAO, Jiping, Sewickley, Pennsylvania 15143 (US); LI, Zilu, Allison Park, Pennsylvania 15101 (US)
(74) Representative: f & e patent

(56) References cited:
- EP-A1- 3 196 678
- WO-A1-2004/056495
- US-A1- 2013 171 344

## Description

### FIELD OF THE INVENTION

The present invention relates to coated articles, including touch screen displays, which comprise substrates coated with an antireflective coating.

### BACKGROUND OF THE INVENTION

Information displays such as touch screen displays are integral components of interactive electronic devices. Because many of these deviced are portable, maximizing visibility of the displays in different lighting environments is an important design aspect. For example, reducing reflection of the screens caused by incident light is an objective. There are various known methods of reducing the reflection of transparent substrate surfaces. An exemplary method involves depositing a light interference coating stack on the substrate that reduces reflection by exploiting the optical interference within adjacent thin films. Such films usually have a thickness of about one-quarter or one-half the nominal wavelength of visible light, depending on the relative indices of refraction of the coatings and substrate. Another method includes forming a light scattering means at the surface of the substrate, such as by mechanically or chemically altering the outermost surface of the substrate or through use of a diffuser coating or a glare reducing film on the glass substrate.

Interference coatings reduce reflection and glare (i. e., bright specular reflection that is perceived by the eye) without reducing resolution. However, they are relatively expensive to deposit, requiring the use of vacuum deposition techniques such as sputtering and precise manufacturing conditions, or very precise alkoxide solution dip coating techniques, with subsequent drying and firing steps. Strict processing parameters must be observed to obtain the desired results.

Anti-glare coatings with fillers are widely used in the coatings industry. Fillers control gloss by affecting the scattering of light with particulates that affect the surface structures of an applied coating.

Etching the outer surface of the substrate or otherwise chemically or mechanically modifying the outer surface of a coating deposited on the substrate has been attempted in an effort to diffuse light. There are numerous drawbacks to such modification techniques. Etching by chemical means involves handling and storage of generally highly corrosive compounds (e.g. hydrofluoric acid). Such compounds create processing and disposal problems in view of increasingly stringent environmental laws. Etching by non-chemical means, such as by sandblasting, necessitates additional and costly processing operations.

WO 2004/056495 A1 is generally related to a process allowing an integrated retailer of ophthalmic lenses to furnish a prescription lens with an antireflective (AR) coating on both sides. This invention is particularly related to a process to furnish such an AR coated lens in a short period of time, by applying a thermally curable hard coating and AR coating in a single spin coater. US 2013/171344 A1 relates to a device, in particular to a cover panel for a display device or a monitor front panel or a surface for inputs including a substrate and a coating applied onto the substrate, use of such a device, as well as a method to produce such a device.

It would be desirable to provide alternative antireflective coatings on a substrate while avoiding the drawbacks of the prior art, and to provide touch screen displays and other optical articles that demonstrate superior visibility properties.

### SUMMARY OF THE INVENTION

Coated articles demonstrating antireflective properties are provided, such as a coated article comprising a multi-layer antireflective coating stack comprising three coating layers of different refractive indices and thicknesses, which together provide antireflective properties.

The present invention provides a coated optical article demonstrating antireflective properties and comprising:
(A) a substrate;
(B) a multi-layer antireflective coating stack comprising
   (a) a first coating layer applied to at least one surface of the substrate, wherein the first coating layer is formed from a sol-gel composition comprising a silane and wherein the first coating layer has a dry film thickness of 44 to 64 nm, and demonstrates a refractive index of 1.62 to 1.85;
   (b) a second coating layer applied to at least one surface of the first coating layer, wherein the second coating layer is formed from a sol-gel composition comprising a silane and wherein the second coating layer has a dry film thickness of 70 to 90 nm, and demonstrates a refractive index of 1.90 to 2.10; and
   (c) a third coating layer applied to at least one surface of the second coating layer, wherein the third coating layer is formed from an acidic sol-gel composition comprising a silane and wherein the third coating layer has a dry film thickness of 74 to 94 nm, and demonstrates a refractive index of 1.40 to 1.48; and
(C) an anti-fouling coating layer applied to at least one surface of the third coating layer.

Also provided is a process comprising: (A) applying a first sol-gel composition to at least one surface of a substrate to form a first coating layer, wherein the first sol-gel composition comprises at least a silane and wherein the first coating layer has a dry film thickness of 44 to 64 nm, and demonstrates a refractive index of 1.62 to 1.85; (B) applying a second sol-gel composition to at least one surface of the first coating layer to form a second coating layer; wherein the second sol-gel composition comprises a silane and wherein the second coating layer has a dry film thickness of 70 to 90 nm, and demonstrates a refractive index of 1.90 to 2.10; (C) applying an acidic sol-gel composition to at least one surface of the second coating layer to form a third coating layer; wherein the acidic sol-gel composition comprises a silane and wherein the third coating layer has a dry film thickness of 74 to 94 nm, and demonstrates a refractive index of 1.40 to 1.48; and (D) applying an anti-fouling coating layer to at least one surface of the third coating layer.

### DETAILED DESCRIPTION OF THE INVENTION

Other than in any operating examples, or where otherwise indicated, all numbers expressing quantities of ingredients, reaction conditions and so forth used in the specification and claims are to be understood as being modified in all instances by the term "about." Accordingly, unless indicated to the contrary, the numerical parameters set forth in the following specification and attached claims are approximations that may vary depending upon the desired properties to be obtained by the present invention. At the very least, and not as an attempt to limit the application each numerical parameter should at least be construed in light of the number of reported significant digits and by applying ordinary rounding techniques.

Notwithstanding that the numerical ranges and parameters setting forth the broad scope of the invention are approximations, the numerical values set forth in the specific examples are reported as precisely as possible. Any numerical value, however, inherently contain certain errors necessarily resulting from the standard deviation found in their respective testing measurements.

Also, it should be understood that any numerical range recited herein is intended to include all sub-ranges subsumed therein. For example, a range of "1 to 10" is intended to include all sub-ranges between (and including) the recited minimum value of 1 and the recited maximum value of 10, that is, having a minimum value equal to or greater than 1 and a maximum value of equal to or less than 10.

As used in this specification and the appended claims, the articles "a," "an," and "the" include plural referents unless expressly and unequivocally limited to one referent.

The various aspects and examples of the present invention as presented herein are each understood to be non-limiting with respect to the scope of the invention.

The coated articles of the present invention comprise three or more coating layers coated on a substrate. Each of the multiple coating layers demonstrates a different refractive index from the layer adjacent. The reflective index and thicknesses of each layer are chosen to produce destructive interference in the light beams reflected from the interfaces, and constructive interference in the corresponding transmitted light beams. As a result, the total reflectance from the coated article is significantly reduced compared to the uncoated substrate. The refractive index and thickness of each layer, and the configuration of the coating stack can be optimized so that the magnitude of the total reflectance reduction from the coated article is maximized. Hence, a multi-layer antireflective coating is defined as an optical coating stack with three or more layers, each with a chosen refractive index and thickness and with a specific order of layers, configured to increase the destructive interference in reflective beams so that the total reflection reduction is maximized. From a different perspective, it may be said that the coating stack is configured to increase the constructive interference in the corresponding transmitted beams so that the total transmittance increase is maximized. Although the antireflective coating performance can be measured by the reflectance from a single side by excluding the reflectance from the other side, or by the total reflectance from both sides, or by the total transmittance, the effect of antireflective coating is better defined as the reduction of the reflectance ΔR from a single side or both sides of a substrate, or the increase of transmittance ΔT. Since the light absorption of the antireflective coating stack is usually negligible, the reduction of the reflectance roughly equals to the increase of the transmittance, i.e. ΔR=ΔT. The greater the ΔR or ΔT, the better the antireflective coating performance. ΔR or ΔT can be calculated from the difference between the reflectance or transmittance of a coated article and that of an uncoated substrate, measured by a spectrophotometer such as a Color i7 spectrophotometer from X-Rite, Inc. In the case of a coating only on a single side of the substrate, the reflectance of the coated article is less than that of an uncoated substrate, or the transmittance of the coated article is more than that of an uncoated substrate for the coating to be considered antireflective. The coated articles of the present invention typically demonstrate a reflectance reduction ΔR or transmittance increase ΔT of ≥ 2.0%, or usually ≥ 2.5%, or most often ≥ 3.0% in a wavelength range from 360 nm to 750 nm. A coated article having three coating layers may demonstrate a reflectance reduction ΔR or transmittance increase ΔT of at least 2.5% in a wavelength range from 360 nm to 750 nm. Furthermore, a coated article having three coating layers may also demonstrate a single-side integrated reflectance reduction ΔR or transmittance increase ΔT greater than 3.0% in a wavelength range from 360 nm to 750 nm. For the purpose of discussion in this invention, the performance of the antireflective coating is remeasured and represented by the transmittance increase, i.e. ΔT, from both sides, as measured by Color i7 spectrophotometer from X-Rite, Inc.

Substrates suitable for use in the coated articles of the present invention can include metals, or more often transparent substrates such as glass, or any of the plastic optical substrates known in the art, which would be suitable for use as a touch screen. The term "optical substrate" means that the specified substrate exhibits a light transmission value (transmits incident light) of at least 4 percent, such as at least 50 percent, or at least 70 percent, or at least 85 percent; and exhibits a haze value of less than 5 percent, e.g., less than 1 percent or less than 0.5 percent, when the haze value is measured at 550 nanometers by, for example, by Color i7 spectrophotometer from X-Rite, Inc. Optical substrates include, but are not limited to, optical articles such as lenses, windows, mirrors, active or passive liquid crystal cell elements or devices, and display elements such as screens, including touch screens on devices including cell phones, tablets, GPS, voting machines, POS (Point-Of-Sale), or computer screens; display sheets in a picture frame; monitors, wearable displays, or security elements. Optical substrates also include optical layers, e.g., optical resin layers, optical films and optical coatings, and optical substrates having a light influencing property.

The term "transparent", as used for example in connection with a substrate, film, material and/or coating, means that the indicated substrate, coating, film and/or material has the property of transmitting light without appreciable scattering so that objects lying beyond are entirely visible with visible light transmittance higher than 70%, preferably higher than 80%, and most preferably higher than 90%.

The substrates typically have at least one flat surface, and often have two opposing surfaces. Either one or both surfaces may be coated with the coatings. Suitable metal substrates include highly polished stainless steel substrates. Suitable glass substrates include soda-lime-silica glass, such as soda-lime-silica slide glass sold from Fisher, or aluminosilicate glass such as Gorilla^{®} glass from Corning Incorporated, or Dragontrail^{®} glass from Asahi Glass Co., Ltd. In particular aspects of the present invention, the substrate is transparent and has at least one flat surface. Suitable examples of plastic substrates include polyol(allyl carbonate) monomers, e.g., poly(allyl diglycol carbonates) such as poly(diethylene glycol bis(allyl carbonate)), which is sold under the trademark CR-39 by PPG Industries, Inc.; polyurea-polyurethane (polyurea urethane) polymers, which are prepared, for example, by the reaction of a polyurethane prepolymer and a diamine curing agent, a composition for one such polymer being sold under the trademark TRIVEX^{®} by PPG Industries, Inc.; polymers of polyol(meth)acryloyl terminated carbonate monomers; diethylene glycol dimethacrylate monomers; ethoxylated phenol methacrylate monomers; diisopropenyl benzene monomers; ethoxylated trimethylol propane triacrylate monomers; ethylene glycol bismethacrylate monomers; poly(ethylene glycol) bismethacrylate monomers; urethane acrylate monomers; poly(ethoxylated Bisphenol A dimethacrylate); poly(vinyl acetate); poly(vinyl alcohol); poly(vinyl chloride); poly(vinylidene chloride); polyethylene; polypropylene; polyurethanes; polythiourethanes; thermoplastic polycarbonates, such as the carbonate-linked resin derived from Bisphenol A and phosgene, one such material being sold under the trademark LEXAN; polyesters, such as the material sold under the trademark MYLAR; poly(ethylene terephthalate); polyvinyl butyral; poly(methyl methacrylate), such as the material sold under the trademark PLEXIGLAS, and polymers prepared by reacting polyfunctional isocyanates with polythiols or polyepisulfide monomers, either homopolymerized or co-and/or terpolymerized with polythiols, polyisocyanates, polyisothiocyanates and optionally ethylenically unsaturated monomers or halogenated aromatic-containing vinyl monomers. Also suitable are copolymers of such monomers and blends of the described polymers and copolymers with other polymers, e.g., to form interpenetrating network products. Also suitable are substrates such as polyamide, cellulose triacetate (TAC), and cyclo olefin polymer (COP).

In the following, a coated article is described comprising a substrate (A) such as any of those described above and a multi-layer antireflective coating stack (B) comprising a first coating layer (a) applied to at least one surface of the substrate, wherein the first coating is formed from a sol-gel composition comprising at least an alkoxysilane and demonstrates a "medium" refractive index of 1.62 to 1.85; and a second coating layer (b) applied to at least one surface of the first coating layer; wherein the second coating layer is formed from an acidic sol-gel composition comprising a silane and demonstrates a "low" refractive index of 1.40 to 1.48. The coated article further comprises an anti-fouling coating layer C) applied to at least one surface of the second coating layer. The refractive indices of different coating layers prepared in this invention were measured between 20°C and 24°C using a F20-UV thin film analyzer from Filmetrics, San Diego, CA.

The first coating is typically applied directly to the substrate surface without an intervening layer such as a hard coat layer or adhesion promotion layer.

The first coating layer may be formed from a curable sol-gel composition comprising:
(1) a resin component comprising:
   (i) tetraalkoxysilane;
   (ii) an epoxy functional trialkoxysilane;
   (iii) a metal-containing catalyst; and
   (iii) a solvent component; and
(2) a particulate component comprising a metal oxide that demonstrates a refractive index of at least 2.0. This curable sol-gel composition is particularly suitable over glass or polymethylmethacrylate substrates. By "curable" is meant that the indicated composition is polymerizable or cross linkable through functional groups, e.g., by means that include, but are not limited to, thermal (including ambient cure), catalytic, electron beam, chemical free-radical initiation, and/or photoinitiation such as by exposure to ultraviolet light or other actinic radiation. By ambient conditions is meant that the coating undergoes a thermosetting reaction without the aid of heat or other energy, for example, without baking in an oven, use of forced air, or the like. Usually ambient temperature ranges from 60 to 90 °F (15.6 to 32.2 °C), such as a typical room temperature, 72°F (22.2°C).

Because of the sol-gel nature of the composition, the tetraalkoxysilanes (i) are hydrolyzed and they are partially condensed prior to curing of the layer. The hydrolyzed tetraalkoxysilane in the sol-gel layer typically comprises tetramethoxysilane and/or tetraethoxysilane.

Suitable epoxy functional trialkoxysilanes (ii), may be selected from 3-glycidoxypropyl trimethoxysilane, and 3-(glycidyloxypropyl)triethoxysilane. The epoxy functional trialkoxysilane may be partially hydrolyzed with water.

A suitable metal-containing catalyst (iii), may be an aluminumcontaining catalyst. Examples include aluminum hydroxychloride or aluminum acetylacetonate. Colloidal aluminum hydroxychloride catalysts are available from Summit Reheis as SUMALCHLOR 50 and from NALCO as NALCO 8676.

The solvent component may include water and one or more polar organic solvents, including ethers such as cyclic ethers, glycol ethers, alcohols having 1 to 6 carbon atoms, such as methanol, ethanol, n-propanol, isopropanol, n-butanol, and the like. Glycol ethers such as propylene glycol methyl ether, propylene glycol methyl ether acetate, dipropylene glycol monomethyl ether, and/or diethylene glycol monobutyl ether are commonly used; very often when the substrate comprises polymethylmethacrylate, the solvent component (d) in the sol-gel composition comprises 1-propanol.

. Exemplary metal oxides that demonstrate a refractive index of at least 2.0 include titanium oxides, such as titanium dioxide, zirconium dioxide, zinc oxide, or tin oxide. The particulate component is usually present in the curable sol-gel composition in an amount of at least 10 percent by weight, or at least 14 percent by weight, or at least 18 percent by weight, and at most 90 percent by weight, or at most 75 percent by weight, or at most 60 percent by weight, based on the total weight of solids in the curable sol-gel composition used to form the first coating layer.

The curable sol-gel composition alternatively may comprise a hydrolyzed titanium alkoxide or zirconium alkoxide with a high refractive index to replace the particulate component comprising a metal oxide that demonstrates a refractive index of at least 2.0. Suitable titanium alkoxides include titanium iso-propoxide and titanium butoxide. Suitable zirconium alkoxides include zirconium(IV) propoxide and zirconium (IV) tert-butoxide.

The curable film-forming sol-gel composition can include a variety of optional ingredients, colorants and/or additives such as any of those disclosed below.

The curable film-forming sol-gel composition typically has a solids content of 0.1 to 35 percent by weight, often 0.5 to 15 percent by weight, more often 1 to 8 percent by weight, based on the total weight of the curable film-forming composition.

Suitable curable sol-gel compositions that may be used as the first coating layer include HI-GARD 1080 and HI-GARD 1080S, both commercially available from PPG Industries, Inc. The sol-gel compositions may also be further diluted with appropriate solvents as described above.

The second coating layer is applied on top of at least one surface of the first coating layer and typically demonstrates a "low" refractive index; i. e., in a range of 1.40 to 1.48. The second coating layer may be formed from an acidic sol-gel composition comprising (i) a tetraalkoxysilane. Again, because of the sol-gel nature of the composition, the alkoxysilanes, when used, are hydrolyzed and they are partially condensed prior to curing of the layer. The hydrolyzed tetraalkoxysilane in the acidic sol-gel composition typically comprises tetramethoxysilane and/or tetraethoxysilane. The tetraalkoxysilane is typically present in the acidic sol-gel composition in an amount less than 7 percent by weight, often less than 6 percent by weight, more often less than 5.5 percent by weight, based on the total weight of the acidic sol-gel composition.

The acidic sol-gel composition may further comprise (ii) an alkyl trialkoxysilane. Examples include methyltrimethoxysilane and methyltriethoxysilane. The alkyl trialkoxysilane is typically present in the acidic sol-gel composition in an amount of 0.1 to 2.5 percent by weight, based on the total weight of the acidic sol-gel composition.

The acidic sol-gel composition may further comprise (iii) a silane-functional acrylic polymer, as identified in U.S. Patent No. 8,148,487 B2 and 8,507,631 B2. By "polymer" is meant a polymer including homopolymers and copolymers, and oligomers. Suitable silane-functional acrylic polymer may be selected from acrylic polymers a silane substituent having at least one and up to three hydrolyzable groups. Examples include a reaction product of hydroxypropyl acrylate and methacryloxypropyltrimethoxy silane. The silane-functional acrylic polymer is typically present in the acidic sol-gel composition in an amount of 0.05 to 7.50 percent by weight, based on the total weight of the acidic sol-gel composition.

The acidic sol-gel composition may further comprise (iv) inorganic oxide particles. The particles can comprise a single inorganic oxide such as silica in colloidal, fumed, or amorphous form, alumina or colloidal alumina, titanium dioxide, cesium oxide, yttrium oxide, colloidal yttria, zirconia, e.g., colloidal or amorphous zirconia, zinc oxide, and mixtures of any of the foregoing; or an inorganic oxide of one type upon which is deposited an inorganic oxide of another type.

The particles are typically present in the acidic sol-gel composition in an amount of 0.05 to 2.0 percent by weight, based on the total solids weight of the acidic sol-gel composition.

The acidic sol-gel composition may further comprise (v) a mineral acid. Suitable mineral acids include sulfuric acid, nitric acid, hydrochloric acid, and the like. Nitric acid is most often used. The mineral acid is typically present in an amount such that the weight ratio of mineral acid to silane is greater than 0.01, often greater than 0.04, more often greater than 0.08, most often greater than 0.1.

The acidic sol-gel composition may additionally comprise (vi) water and (vii) a solvent such as a glycol ether or lower alcohol. Suitable lower alcohols include ethanol, n-propanol, isopropanol, n-butanol, isobutanol, and the like, including mixtures thereof. Examples of glycol ethers include propylene glycol methyl ether, propylene glycol methyl ether acetate, dipropylene glycol monomethyl ether, and/or diethylene glycol monobutyl ether. Note that the phrase "and/or" when used in a list is meant to encompass alternative embodiments including each individual component in the list as well as any combination of components. For example, the list "A, B, and/or C" is meant to encompass seven separate embodiments that include A, or B, or C, or A + B, or A + C, or B + C, or A + B + C.

The water (f) is typically present in the acidic sol-gel composition in an amount of 0.1 to 35.0 percent by weight, based on the total weight of the acidic sol-gel composition, and the solvent is typically present in the acidic sol-gel composition in an amount of 60 to 98 percent by weight, based on the total weight of the acidic sol-gel composition. This allows for a total solids content of at least 0.1 percent by weight, or at least 0.5 percent by weight, or at least 2.0 percent by weight; and a total solids content of at most 35 percent by weight, or at most 20 percent by weight, or at most 10 percent by weight. For example, the acidic sol-gel composition typically has a solids content of 0.1 to 10 percent by weight, often 0.5 to 10 percent by weight, more often 1 to 8 percent by weight, usually less than 7 percent by weight or less than 5 percent by weight, based on the total weight of the acidic sol-gel composition.

In certain examples of the present invention, the second coating layer prepared from the acidic sol-gel composition is essentially free of fluorine. By "essentially free" of a material is meant that a composition has only trace or incidental amounts of a given material, and that the material is not present in an amount sufficient to affect any properties of the composition. These materials are not essential to the composition and hence the composition is free of these materials in any appreciable or essential amount. If they are present, it is in incidental amounts only, typically less than 0.1 percent by weight, based on the total weight of solids in the composition.

Both the first and the second coating layers may independently be applied to at least one surface of the substrate by any of the methods described below. In various scenarios, the first coating layer may be applied to one surface of the substrate and the second coating layer applied on top of the first layer; the first coating layer may be applied to two opposing surfaces of the substrate and the second coating layer applied on top of the first layer on only one surface; or the first coating layer may be applied to two opposing surfaces of the substrate and the second coating layer applied on top of the first layer on both surfaces.

The present invention further provides a coated article comprising
(A) a substrate such as any of those described above;
(B) a multi-layer antireflective coating stack comprising
   (a) a first coating layer applied to at least one surface of the substrate; wherein the first coating layer is formed from a sol-gel composition comprising a silane and wherein the first coating layer demonstrates a "medium" refractive index of 1.62 to 1.85;
   (b) a second coating layer applied to at least one surface of the first coating layer; wherein the second coating layer is formed from a sol-gel composition comprising a silane and wherein the second coating layer demonstrates a "high" refractive index of 1.90 to 2.10;
   (c) a third coating layer applied to at least one surface of the second coating layer; wherein the third coating layer is formed from an acidic sol-gel composition comprising a silane and wherein the third coating layer demonstrates a "low" refractive index of 1.40 to 1.48; and
(C) an anti-fouling coating layer applied to at least one surface of the third coating layer.

Each of the first, second, and third coating layers may independently comprise any of the compositions described above, including any optional ingredients, with different refractive indices achieved by adjusting the weight ratio of silane to inorganic oxide particles.

The first and/or second coating layer may be independently formed from a curable sol-gel composition comprising:
(1) a resin component comprising:
   (a) tetraalkoxysilane;
   (b) an epoxy functional trialkoxysilane;
   (c) a metal-containing catalyst; and
   (d) a solvent component; and
(2) a particulate component comprising a titanium oxide, present in the curable sol-gel composition in an amount of 10 to 90 percent by weight, based on the total weight of solids in the curable sol-gel composition. The resin component (1) may comprise any of the materials noted above for each ingredient. The use of the above composition as both the first and second coating layers is particularly useful over substrates that comprise sheets having two opposing surfaces. In this example, the weight ratio of the resin component (1) to the particulate component (2) in each of the first and second layers is different to allow for different refractive indices, and the coated article typically demonstrates a transmittance increase of 2.0% or more in a wavelength range from 360 nm to 750 nm.

The third coating layer (c) may be formed from a curable sol-gel composition comprising (i) tetraalkoxysilane; (ii) alkyl trialkoxysilane; (iii) a silane-functional acrylic polymer; (iv) inorganic oxide particles; (v) a mineral acid; (vi) water; and (vii) a solvent. In certain examples of the present invention, the third coating layer prepared from the acidic sol-gel composition is essentially free of fluorine.

When the multi-layer antireflective coating stack of the present invention comprises three layers, the first coating layer typically has a dry film thickness of 44 to 64 nm, and the second coating layer usually has a dry film thickness of 70 to 90 nm, and the third coating layer usually has a dry film thickness of 74 to 94 nm.

Each of the sol-gel compositions used in each layer of the multi-layer coated articles of the present invention can independently include a variety of optional ingredients and/or additives that are somewhat dependent on the particular application of the final coated article. For example, any of the compositions may exhibit a light influencing property. Other optional ingredients include rheology control agents, surfactants, initiators, catalysts, cure-inhibiting agents, reducing agents, acids, bases, preservatives, free radical donors, free radical scavengers and thermal stabilizers, which adjuvant materials are known to those skilled in the art.

The sol-gel compositions may include a colorant, although typically the compositions are colorless and transparent. They are also usually optically clear, having a light transmission of at least 70% or demonstrating a haze value less than 50% depending on gloss level.

The coated articles of the present invention further comprise an anti-fouling coating layer applied to at least one surface of the outermost coating layer; i. e., if the multi-layer antireflective coating stack comprises two coating layers, the anti-fouling coating layer is applied on top of the second coating layer. If the multi-layer antireflective coating stack comprises three coating layers, the anti-fouling coating layer is applied on top of the third coating layer. Additionally, if one or more coating layers are applied to two opposing surfaces of the substrate, the anti-fouling layer may be applied to either one or both of the coated surfaces. The anti-fouling coating layer may be applied using any of those methods disclosed below. Suitable anti-fouling coating compositions include any of those known in the art.

The coated articles described above comprising a multi-layer antireflective coating stack having three coating layers may be prepared by a process according to the present invention comprising:
(A) applying a first sol-gel composition to a surface of a substrate to form a first coating layer, wherein the first sol-gel composition comprises at least a silane and wherein the first coating layer has a dry film thickness of 44 to 64 nm, and demonstrates a refractive index of 1.62 to 1.85;
(B) applying a second sol-gel composition to the first coating layer to form second coating layer; wherein the second sol-gel composition comprises a silane and wherein the second coating layer has a dry film thickness of 70 to 90 nm, and demonstrates a refractive index of 1.90 to 2.10;
(C) applying an acidic sol-gel composition to the second coating layer to form a third coating layer; wherein the acidic sol-gel composition comprises a silane and wherein the third coating layer has a dry film thickness of 74 to 94 nm, and demonstrates a refractive index of 1.40 to 1.48; and
(D) applying an anti-fouling coating layer to the third coating layer. Each of the respective coating layers are as described above.

The compositions that form the coating layers may each be applied to the substrate by one or more of a number of methods such as spray coating, dip coating (immersion), spin coating, slot die coating, or flow coating onto a surface thereof. Spraying is used most often, such as ultrasonic spray application, precision spray application, and air atomized spray application. The coating compositions may be kept at ambient temperature immediately prior to application. Again, at least one surface of the substrate is coated; if the substrate has two opposing surfaces, either one or both surfaces may be coated.

After application of the sol-gel layers, the coated substrate is then subjected to conditions for a time sufficient to effect cure of the sol-gel layers and form an anti-refelctive coated article. The term "cure", "cured" or similar terms, as used in connection with a cured or curable composition, e.g., a "cured composition" of some specific description, means that at least a portion of any polymerizable and/or crosslinkable components that form the curable composition is polymerized and/or crosslinked. Additionally, curing of a composition refers to subjecting said composition to curing conditions such as those listed above, leading to the reaction of the reactive functional groups of the composition. The term "at least partially cured" means subjecting the composition to curing conditions, wherein reaction of at least a portion of the reactive groups of the composition occurs. The compositions can also be subjected to curing conditions such that a substantially complete cure is attained and wherein further curing results in no significant further improvement in physical properties, such as hardness. For example, the coated substrate may be heated to a temperature of at least 120°C for at least 0.5 hours, to promote the continued polymerization of the composition. In particular examples, the coated substrate may be heated to a temperature of 120°C for at least 3 hours, or the coated substrate may be heated to a temperature of at least 150°C for at least 1 hour, or the coated substrate may be heated to a temperature of at least 450°C for at least 0.5 hour.

When the multi-layer antireflective coating stack of the present invention comprises three layers, the first coating layer typically has a dry film thickness of 44 to 64 nm, the second coating layer usually has a dry film thickness of 70 to 90 nm, and the third coating layer usually has a dry film thickness of 74 to 94 nm.

The coated articles of the present invention comprising a multi-layer antireflective coating stack having three layers often demonstrate a transmittance increase of more than 3.0% in a wavelength range of 360 to 750 nm. For example, when the substrate is glass, the coated article may demonstrate a transmittance increase of more than 3.0% in a wavelength range of 360 to 750 nm.

Coated articles of the present invention demonstrate reduced reflection without reducing resolution of a display viewed through the article. This is particularly advantageous when the coated article is an optical article such as a screen, in particular, a touch screen, for an electronic device such as a phone, monitor, tablet, or the like.

Each of the aspects and characteristics described above, and combinations thereof, may be said to be encompassed by the present invention. For example, the present invention is thus drawn to the following nonlimiting aspects:

In a first aspect, a coated article is provided that comprises: (A) a substrate; (B) a multi-layer antireflective coating stack comprising (a) a first coating layer applied to at least one surface of the substrate; wherein the first coating layer has a dry film thickness of 44 to 64 nm, and is formed from a sol-gel composition comprising a silane and wherein the first coating layer demonstrates a refractive index of 1.62 to 1.85; (b) a second coating layer applied to at least one surface of the first coating layer; wherein the second coating layer has a dry film thickness of 70 to 90 nm, and is formed from a sol-gel composition comprising a silane and wherein the second coating layer demonstrates a refractive index of 1.90 to 2.10; (c) a third coating layer applied to at least one surface of the second coating layer; wherein the third coating layer has a dry film thickness of 74 to 94 nm, and is formed from an acidic sol-gel composition comprising a silane and wherein the third coating layer demonstrates a refractive index of 1.40 to 1.48; and (C) an anti-fouling coating layer applied to at least one surface of the third coating layer.

In a second aspect of the coated article according to aspect one, the substrate (A) comprises glass, polymethylmethacrylate, polycarbonate, polyethylene terephthalate (PET), polyurea-urethane, polyamide, cellulose triacetate (TAC), cyclo olefin polymer (COP), or poly(allyl diglycol carbonate).

In a third aspect of the coated article according to any of aspects one or two, the first coating layer (a) is formed from a sol-gel composition comprising: (1) a resin component comprising: (i) tetraalkoxysilane; (ii) an epoxy functional trialkoxysilane; (iii) a metal-containing catalyst; and (iv) a solvent component; and (2) a particulate component comprising titanium oxide or zirconium oxide, present in the sol-gel composition in an amount from 20 to 70 percent by weight, based on the total weight of solids in the sol-gel composition used to form the first coating layer (a).

In a fourth aspect of the coated article according to any of aspects one to three, the second coating layer (b) is formed from a sol-gel composition comprising: (1) a resin component comprising: (i) tetraalkoxysilane; (ii) an epoxy functional trialkoxysilane; (iii) a metal-containing catalyst; and (iv) a solvent component; and (2) a particulate component comprising titanium oxide or zirconium oxide, present in the sol-gel composition in an amount from 40 to 95 percent by weight, based on the total weight of solids in the sol-gel composition used to form the second coating layer (C).

In a fifth aspect of the coated article according to any of aspects one to four, the third coating layer (c) is formed from an acidic sol-gel composition comprising: (i) tetraalkoxysilane; (ii) alkyl trialkoxysilane; (iii) a silane-functional acrylic polymer; (iv) inorganic oxide particles; (v) a mineral acid; (vi) water; and (vii) a solvent.

In a sixth aspect of the coated article according to any of aspects one to five, the substrate comprises glass and the coated article demonstrates a transmittance increase greater than 3.0% in a wavelength range from 360 nm to 750 nm.

In a seventh aspect of the coated article according to any of aspects one to six the substrate has two opposing surfaces.

In an eighth aspect of the coated article according to any of aspects one to seven, said coated article is an optical article comprising a display element, window, mirror, and/or active and passive liquid crystal cell element or device.

In a nineth aspect of the coated article according to any of aspects one to eigth, the coated article demonstrates a transmittance increase ΔT of at least 2.5% in a wavelength range from 360 nm to 750 nm.

In a tenth aspect, a process of forming a coated article that demonstrates antireflective properties is provided comprising: (A) applying a first sol-gel composition to at least one surface of a substrate to form a first coating layer, wherein the first sol-gel composition comprises at least a silane and wherein the first coating layer has a dry film thickness of 44 to 64 nm, and demonstrates a refractive index of 1.62 to 1.85; (B) applying a second sol-gel composition to at least one surface of the first coating layer to form second coating layer; wherein the second sol-gel composition comprises a silane and wherein the second coating layer has a dry film thickness of 70 to 90 nm, and demonstrates a refractive index of 1.90 to 2.10; (C) applying an acidic sol-gel composition to at least one surface of the second coating layer to form a third coating layer; wherein the acidic sol-gel composition comprises a silane and wherein the third coating layer has a dry film thickness of 74 to 94 nm, and demonstrates a refractive index of 1.40 to 1.48; and (D) applying an anti-fouling coating layer to the third coating layer.

In an eleventh aspect of the process according to aspect ten, the coatings are each independently applied by a slot-die coating process, a spray-coating process, a spin-coating process, or a dip-coating process.

In a twelfth aspect, a coated article is provided comprising: (A) a substrate; (B) a first coating layer applied to at least one surface of the substrate; wherein the first coating layer has a dry film thickness of 44 to 64 nm, and is formed from a sol-gel composition comprising a silane and wherein the first coating layer demonstrates a refractive index of 1.62 to 1.85; (C) a second coating layer applied to at least one surface of the first coating layer; wherein the second coating layer has a dry film thickness of 70 to 90 nm, and is formed from a sol-gel composition comprising a silane and wherein the second coating layer demonstrates a refractive index of 1.90 to 2.10; (D) a third coating layer applied to at least one surface of the second coating layer; wherein the third coating layer has a dry film thickness of 74 to 94 nm, and is formed from an acidic sol-gel composition comprising a silane and wherein the third coating layer demonstrates a refractive index of 1.40 to 1.48; and (E) an anti-fouling coating layer applied to at least one surface of the third coating layer.

In a thirteenth aspect of the coated article of aspect twelve the substrate (A) comprises glass, polymethylmethacrylate, polycarbonate, polyethylene terephthalate (PET), polyurea-urethane, polyamide, cellulose triacetate (TAC), cyclo olefin polymer (COP), or poly (allyl diglycol carbonate).

In a fourteenth aspect of the coated article of aspect twelve, the first coating layer (B) is formed from a sol-gel composition comprising: (1) a resin component comprising: (a) tetraalkoxysilane; (b) an epoxy functional trialkoxysilane; (c) a metal-containing catalyst; and (d) a solvent component; and(2) a particulate component comprising titanium oxide or zirconium oxide, present in the sol-gel composition in an amount from 20 to 70 percent by weight, based on the total weight of solids in the sol-gel composition used to form the first coating layer (B).

In a fifteenth aspect of the coated article of aspect twelve, the second coating layer (C) is formed from a sol-gel composition comprising: (1) a resin component comprising: (a) tetraalkoxysilane; (b) an epoxy functional trialkoxysilane; (c) a metal-containing catalyst; and (d) a solvent component; and (2) a particulate component comprising titanium oxide or zirconium oxide, present in the sol-gel composition in an amount from 40 to 95 percent by weight, based on the total weight of solids in the sol-gel composition used to form the second coating layer (C).

In a sixteenth aspect of the coated article of aspect twelve, the third coating layer (D) is formed from an acidic sol-gel composition comprising: (a) tetraalkoxysilane; (b) alkyl trialkoxysilane; (c) a silane-functional acrylic polymer; (d) inorganic oxide particles; (e) a mineral acid; (f) water; and (g) a solvent.

In a seventeenth aspect of the coated article of aspect twelve, the substrate comprises glass and the coated article demonstrates a or transmittance increase greater than 3.0% in a wavelength range from 360 nm to 750 nm.

In an eighteenth aspect of the coated article of aspect twelve, the substrate has two opposing surfaces.

In a nineteenth aspect of the coated article of aspect twelve, said coated article is an optical article comprising a display element, window, mirror, and/or active and passive liquid crystal cell element or device.

In a twentennth aspect of the coated article of aspect twelve, the coated article demonstrates a transmittance increase ΔT of at least 2.5% in a wavelength range from 360 nm to 750 nm.

In a twenty-first aspect, a process of forming a coated article is provided that demonstrates antireflective properties comprising: (A) applying a first sol-gel composition to at least one surface of a substrate to form a first coating layer, wherein the first sol-gel composition comprises at least a silane and wherein the first coating layer has a dry film thickness of 44 to 64 nm, and demonstrates a refractive index of 1.62 to 1.85; (B) applying a second sol-gel composition to at least one surface of the first coating layer to form second coating layer; wherein the second sol-gel composition comprises a silane and wherein the second coating layer has a dry film thickness of 70 to 90 nm, and demonstrates a refractive index of 1.90 to 2.10; (C) applying an acidic sol-gel composition to at least one surface of the second coating layer to form a third coating layer; wherein the acidic sol-gel composition comprises a silane and wherein the third coating layer has a dry film thickness of 74 to 94 nm, and demonstrates a refractive index of 1.40 to 1.48; and (D) applying an anti-fouling coating layer to the third coating layer.

In a twenty-second aspect of the process of aspect twenty-one, each coating is independently applied by a slot-die coating process, a spray-coating process, a spin-coating process, or a dip-coating process.

The following examples are intended to illustrate various aspects of the invention, and should not be construed as limiting the invention in any way.

### EXAMPLES

### Example 1: Preparation of titanium oxide sol

In a clean 1000 mL plastic container, 100 grams of propylene glycol monomethyl ether (PM) was mixed with 100 grams of propylene glycol monomethyl ether acetate (PMA). A sol-gel precursor solution was prepared by adding 200 grams of titanium iso-propoxide (97%, Sigma Aldrich) into the PM/PMA mixture under stirring. In a separate, clean 1000 mL plastic container, 40 grams of 70% nitric acid was added into 400 grams of deionized water to form an acidic solution. This acidic solution was added into the above precursor solution under vigorous stirring. White precipitates occurred upon adding the acidic solution, and after stirring for 24 hours the hydrolyzed solution became transparent without precipitation or gelation. The titanium oxide sol was stored in a freezer for future use.

### Example 2: Preparation of a sol-gel solution for a sol-gel derived coating with a refractive index of 1.68±0.02

Solution A was prepared by mixing 618.15 grams of isopropyl alcohol and 181.85 grams of deionized water in a 1000 mL plastic container. 113.44 grams of the pre-prepared titanium oxide sol was added into a 1000 mL clean plastic container, followed by mixing with 8.32 grams of acetyl acetone (≥ 99%), 32.32 grams of Hi-Gard 1080s commercially available from PPG, 288.8 grams of solution A, 0.8 grams of BYK 306 (available from BYK) and 443.68 grams of 1-propanol under stirring for one hour. The Acetyl acetone was added before Hi-Gard 1080s to stabilize the titanium oxide sol. The refractive index of thin film prepared from this sol was 1.66 to 1.70 as measured between 20°C and 24°C by F20-UV thin film analyzer from Filmetrics, San Diego, CA.

### Example 3: Preparation of a sol-gel solution for a sol-gel derived coating with a refractive index of 1.78±0.02

116.64 grams of pre-prepared titanium oxide sol (Example 1) was added into a 1000 mL clean plastic container, followed by mixing with 8.64 grams of acetyl acetone, 15.58 grams of Hi-Gard 1080s, 259.68 grams of solution A, 0.64 grams of BYK 306 and 401.18 grams of 1-propanol under stirring for one hour. The refractive index of thin film prepared from this sol was 1.76 to 1.80 as measured between 20°C and 24°C by F20-UV thin film analyzer from Filmetrics, San Diego, CA.

### Example 4: Preparation of a sol-gel solution for a sol-gel derived coating with a refractive index of 1.97±0.03

174.4 grams of pre-prepared titanium oxide sol (Example 1) was added into a 1000 mL clean plastic container, followed by mixing with 12.8 grams of acetyl acetone, 259.68 grams of solution A, 0.64 grams of BYK 306 and 401.18 grams of 1-propanol under stirring for one hour. The refractive index of thin film prepared from this sol was 1.94 to 2.00 as measured between 20°C and 24°C by F20-UV thin film analyzer from Filmetrics, San Diego, CA.

### Example 5: Preparation of low refractive index sol-gel solution for a coating with n = 1.44±0.01

Part A: In a clean container, 11.5 parts of tetraethyl orthosilicate (98% purity, Sigma-Aldrich Corporation) is mixed with 0.75 parts of a silane functional acrylic polymer. The silane functional acrylic polymer was prepared in accordance with Example 1 of United States Patent Number 8,507,631, with the following differences: t-amyl peroxy-2-ethylhexanoate was used as an initiator instead of azobisisobutyronitrile, and the solution was placed in an oven at 120°C (248°F) instead of 82°C (180°F) overnight., 1.72 parts of colloidal silica MT-ST (Nissan Chemical), and 2.8 parts of methyltrimethoxysilane (Evonik). After mixing for 30 minutes, a mixture of 6.8 parts of 2-propanol (99.5% purity, Sigma-Aldrich Corporation), 2.1 parts of deionized water, and 2.5 parts of an aqueous solution of HNO₃ (4.68 percent by weight nitric acid in water) was added to the first mixture to hydrolyze silanes. After 30 minutes hydrolysis, 0.25 parts of aluminum acetylacetonate (99% purity, Sigma-Aldrich Corporation) and 0.3 parts of BYK-306 (BYK USA Inc.) was added to the mixture. Finally, an amount of 71.28 parts of 2-propanol is added to dilute the solution while mixing.

Part B: In a clean container, 13.33 parts of the solution in Part A above is mixed with 86.67 parts of n-propanol for 30 min.

The refractive index of thin film prepared from this composition was 1.43 to 1.45 as measured between 20°C and 24°C by F20-UV thin film analyzer from Filmetrics, San Diego, CA.

### Example 6: Two-layer antireflective (AR) system prepared by spin coating (not according to the invention)

A soda lime glass or microscopic slide glass substrate was cleaned by isopropyl alcohol and pre-treated with nitrogen plasma treatment for 15 min using an ATTO plasma treater (Diener Electronics, Germany). The first layer consisting of a coating from the solution in Example 2 was coated using a Cee 200X spin-coater (Brewer Science, Inc.) onto the substrate, followed by curing at 150°C for one hour. The film thickness was adjusted by using different spin speeds (500 to 2000 rpm), and optimal thickness was in the range of 100 to 140 nm. The second layer consisting of a coating from the solution in Example 5 was spin coated on top of the first layer after nitrogen plasma treatment for 15 minutes. The film thickness of the second layer was in the range of 70 to 90 nm. The coated samples exhibited an increase of 2.7% to 3% of the integrated transmittance in the 360 to 750 nm visible light wavelength range. No haze was observed. Afterwards, an anti-fouling coating available from PPG as EC1103 was applied using a Prism Ultra-Coat ultrasonic spray coater, followed by curing at 150°C for 1 hour. The water contact angle increased from 16° to above 110°. Table 1 demonstrates transmittance T and haze of the coated article compared to the uncoated glass substrate as measured by a Color i7 spectrophotometer from X-Rite, Inc. The antireflective effect is demonstrated by the increase of transmittance ΔT, calculated as the transmittance increase of the coated article compared to that of the uncoated glass substrate.

**Table 1 Optical data for two-layer AR coating by spin coating from Example 6**

| Example 6 | T (%) | ΔT (%) | Haze (%) |
|---|---|---|---|
| Uncoated soda lime glass | 91.44 | 2.86 | 0 |
| Two-layer AR on soda lime glass | 94.30 | | 0 |

### Example 7: Two-layer antireflective (AR) system prepared by ultrasonic spraying (not according to the invention)

A soda lime glass substrate was cleaned with isopropyl alcohol, pre-treated with nitrogen plasma treatment for 15 min using an ATTO plasma treater (Diener Electronics, Germany), and coated with a coating from the solution of Example 2 as a 1^{st} layer (n = 1.68) and a second coating from the solution in Example 5 as a 2^{nd} layer (n = 1.44) by ultrasonic spraying. Film thickness was adjusted by controlling the head speed and flow rate, and ±10 nm film thickness variation was observed. 1^{st} layer film thickness was around 80-100 nm, and 2^{nd} layer film thickness was around 70 nm. Samples were cured at 150°C for one hour after each coating process. Coated samples exhibited an increase of 3% of integrated transmittance in the 360 to 750 nm visible light wavelength range. Thereafter an anti-fouling coating available from PPG as EC1103 was applied using a Prism Ultra-Coat ultrasonic spray coater and cured at 150°C for 1 hour.

### Example 7: Optical data for two-layer AR coating by ultrasonic spraying

| | T (%) | ΔT(%) | Haze (%) |
|---|---|---|---|
| Uncoated soda lime glass | 91.44 | 3.12 | 0 |
| Two-layer AR on soda lime glass | 94.56 | | 0 |

### Example 8: Two-layer antireflective (AR) system prepared by slot die coating process (not according to the invention)

A soda lime glass substrate was cleaned with isopropyl alcohol, fitted into a specifically designed plastic shim and placed on a marble with vacuum channels. Two-layer AR coatings using the solutions in Example 2 as the first layer, and Example 5 as the second layer were sequentially coated on the soda lime glass, and each layer was cured at 150°C for one hour after the coating process. The film thickness can be adjusted by flow rate and gap between die and substrate. Best film thickness uniformity of ±2 nm was achieved by slot die coating. A coating stack of 107±2nm for the first layer and 84±2 nm for the second layer was successfully prepared on the substrate. As-prepared samples exhibited an increase of 3% of integrated transmittance in the 360 to 750 nm visible light wavelength range with a 0.45% haze. Then an anti-fouling coating available from PPG as EC1103 was applied using a Prism Ultra-Coat ultrasonic spray coater and cured at 100°C for 10 minutes.

### Example 8: Optical data for two-layer AR sample by slot die coating process

| Example 8 | T(%) | ΔT(%) | Haze (%) |
|---|---|---|---|
| Uncoated soda lime glass | 91.44 | 3.03 | 0 |
| Two-layer AR on soda lime glass | 94.47 | | 0.45 |

### Example 9: Three-layer antireflective (AR) coating stack prepared by spin coating

A soda lime glass substrate was cleaned with isopropyl alcohol, and treated with nitrogen plasma treatment for 15 min using an ATTO plasma treater (Diener Electronics, Germany). A coating from the solution in Example 3 was spin coated on the glass substrate as the first layer. The coating was then dried at 80°C for 20 minutes. A second coating from the solution in Example 4 was spin coated as the second layer followed by drying at 80°C for 20 minutes. Thereafter, a coating from the solution in Example 5 was coated as the third layer. The final coating stack was then cured at 500°C for one hour. Then an anti-fouling coating available from PPG as EC1103 was applied using a Prism Ultra-Coat ultrasonic spray coater and cured at 100°C for 10 minutes. The average film thickness for the first layer, the second layer and the third layer of the multi-layer antireflective coating were 53 nm, 88 nm, and 82 nm, respectively. The three-layer AR coating stack with EC1103 coating exhibited an increase of 3.1 % of integrated transmittance in the 360 nm to 750 nm visible light wavelength range.

### Example 9: Optical data for three-layer AR coating stack by spin coating

| Example 9 | T | ΔT (%) | Haze (%) |
|---|---|---|---|
| Uncoated micro slide glass | 91.9 | 3.1 | 0 |
| Three-layer AR on micro slide glass | 95.0 | | 0.48 |

### Example 10: TF-Calc simulation of three-layer antireflective coatings

Examples 10-A to 10-E are simulated three-layer antireflective coatings using TF-Calc software from Software Spectra, Inc. The simulation uses pre-set film thickness and refractive index for each coating layer and calculates the transmittance (T) of various single-side, three-layer coatings on the glass surface. The uncoated glass has a transmittance of 91.83%, Example 10-A has a transmittance of 95.19% with a ΔT of 3.36%, Example 10-B a transmittance of 95.24% with a ΔT of 3.41%, and Example 10-C a transmittance of 95.39% with a ΔT of 3.56%. However, when the film thickness of the second layer is 105 nm and third layer is 110 nm (i. e., outside the range of the second and third layers in the coated articles of the present invention), the Comparative Example 10-D has a transmittance of 94.28% with a ΔT of only 2.45%. For Comparative Example 10-E, its transmittance is 93.52% with a ΔT of only 1.69%. This indicates that when the film thickness of any coating layer is outside the range specified above, the transmittance will reduce significantly, and/or the tramsmittance increase ΔT will be significantly reduced.

| Example | Uncoated glass | Example 10-A | Example 10-B | Example 10-C | Example 10-D | Example 10-E |
|---|---|---|---|---|---|---|
| 1^{st} layer n | N/A | 1.8 | 1.8 | 1.8 | 1.8 | 1.8 |
| 1^{st} layer thickness (nm) | N/A | 64 | 44 | 54 | 64 | 44 |
| 2^{nd} layer n | N/A | 2 | 2 | 2 | 2 | 2 |
| 2^{nd} layer thickness (nm) | N/A | 90 | 70 | 80 | 105 | 105 |
| 3^{rd} layer n | N/A | 1.455 | 1.455 | 1.455 | 1.455 | 1.455 |
| 3^{rd} layer thickness (nm) | N/A | 94 | 74 | 84 | 110 | 110 |
| EC1103 layer n | N/A | 1.3 | 1.3 | 1.3 | 1.3 | 1.3 |
| EC1103 layer thickness (nm) | N/A | 10 | 10 | 10 | 10 | 10 |
| T (%) | 91.83 | 95.19 | 95.24 | 95.39 | 94.28 | 93.52 |
| ΔT (%) | N/A | 3.36 | 3.41 | 3.56 | 2.45 | 1.69 |

## Claims

1. A coated optical article comprising:
(A) a substrate;
(B) a multi-layer antireflective coating comprising
(a) a first coating layer applied to at least one surface of the substrate; wherein the first coating layer has a dry film thickness of 44 to 64 nm, and is formed from a sol-gel composition comprising a silane and wherein the first coating layer demonstrates a refractive index of 1.62 to 1.85;
(b) a second coating layer applied to at least one surface of the first coating layer; wherein the second coating layer has a dry film thickness of 70 to 90 nm, and is formed from a sol-gel composition comprising a silane and wherein the second coating layer demonstrates a refractive index of 1.90 to 2.10;
(c) a third coating layer applied to at least one surface of the second coating layer; wherein the third coating layer has a dry film thickness of 74 to 94 nm, and is formed from an acidic sol-gel composition comprising a silane and wherein the third coating layer demonstrates a refractive index of 1.40 to 1.48; and
(C) an anti-fouling coating layer applied to at least one surface of the third coating layer.

2. The coated article of claim 1, wherein the substrate (A) comprises glass, polymethylmethacrylate, polycarbonate, polyethylene terephthalate (PET), polyurea-urethane, polyamide, cellulose triacetate (TAC), cyclo olefin polymer (COP), or poly (allyl diglycol carbonate).

3. The coated article according to any of claims 1 or 2, wherein the first coating layer (a) is formed from a sol-gel composition comprising:
(1) a resin component comprising:
(i) tetraalkoxysilane;
(ii) an epoxy functional trialkoxysilane;
(iii) a metal-containing catalyst; and
(iv) a solvent component; and
(2) a particulate component comprising titanium oxide or zirconium oxide, present in the sol-gel composition in an amount from 20 to 70 percent by weight, based on the total weight of solids in the sol-gel composition used to form the first coating layer (a);

4. The coated article according to any of claims 1 to 3, the second coating layer (b) is formed from a sol-gel composition comprising:
(1) a resin component comprising:
(i) tetraalkoxysilane;
(ii) an epoxy functional trialkoxysilane;
(iii) a metal-containing catalyst; and
(iv) a solvent component; and
(2) a particulate component comprising titanium oxide or zirconium oxide, present in the sol-gel composition in an amount from 40 to 95 percent by weight, based on the total weight of solids in the sol-gel composition used to form the second coating layer (C);

5. The coated article according to any of claims 1 to 4, the third coating layer (c) is formed from an acidic sol-gel composition comprising:
(i) tetraalkoxysilane;
(ii) alkyl trialkoxysilane;
(iii) a silane-functional acrylic polymer;
(iv) inorganic oxide particles;
(v) a mineral acid;
(vi) water; and
(vii) a solvent.

6. The coated article according to any of claims 1 to 5, wherein the substrate has two opposing surfaces.

7. The coated article according to any of claims 1 to 6, wherein said coated article is an optical article comprising a display element, window, mirror, and/or active and passive liquid crystal cell element or device.

8. A process of forming a coated optical article that demonstrates antireflective properties comprising:
(A) applying a first sol-gel composition to at least one surface of a substrate to form a first coating layer, wherein the first sol-gel composition comprises at least a silane and wherein the first coating layer has a dry film thickness of 44 to 64 nm, and demonstrates a refractive index of 1.62 to 1.85;
(B) applying a second sol-gel composition to at least one surface of the first coating layer to form second coating layer; wherein the second sol-gel composition comprises a silane and wherein the second coating layer has a dry film thickness of 70 to 90 nm, and demonstrates a refractive index of 1.90 to 2.10;
(C) applying an acidic sol-gel composition to at least one surface of the second coating layer to form a third coating layer; wherein the acidic sol-gel composition comprises a silane and wherein the third coating layer has a dry film thickness of 74 to 94 nm, and demonstrates a refractive index of 1.40 to 1.48; and
(D) applying an anti-fouling coating layer to the third coating layer.

9. The process of claim 8, wherein each coating is independently applied by a slot-die coating process, a spray-coating process, a spin-coating process, or a dip-coating process.

## Patentansprüche

1. Ein beschichteter optischer Gegenstand umfassend:
(A) ein Substrat,
(B) ein mehrschichtige Antireflexionsbeschichtung umfassend
(a) eine erste Beschichtungsschicht, die auf zumindest einer Oberfläche des Substrats aufgebracht ist, wobei die erste Beschichtungsschicht eine Trockenfilmdicke von **44** bis 64 nm aufweist und aus einer Sol-Gel-Zusammensetzung, enthaltend ein Silan, gebildet ist und wobei die erste Beschichtungsschicht einen Brechungsindex von 1,62 bis 1,85 aufweist,
(b) eine zweite Beschichtungsschicht, die auf zumindest einer Oberfläche der ersten Beschichtungsschicht aufgebracht ist, wobei die zweite Beschichtungsschicht eine Trockenfilmdicke von 70 bis 90 nm aufweist und aus einer Sol-Gel-Zusammensetzung, enthaltend ein Silan, gebildet ist und wobei die zweite Beschichtungsschicht einen Brechungsindex von 1,90 bis 2,10 aufweist,
(c) eine dritte Beschichtungsschicht, die auf zumindest einer Oberfläche der zweiten Beschichtungsschicht aufgebracht ist, wobei die dritte Beschichtungsschicht eine Trockenfilmdicke von 74 bis 94 nm aufweist und aus einer sauren Sol-Gel-Zusammensetzung, enthaltend ein Silan, gebildet ist und wobei die dritte Beschichtungsschicht einen Brechungsindex von 1,40 bis 1,48 aufweist, und
(C) eine bewuchshemmende Beschichtungsschicht, die auf zumindest einer Oberfläche der dritten Beschichtungsschicht aufgebracht ist.

2. Beschichteter Gegenstand gemäß Anspruch 1, wobei das Substrat (A) Glas, Polymethylmethacrylat, Polycarbonat, Polyethylenterephthalat (PET), Polyharnstoffurethan, Polyamid, Cellulosetriacetat (TAC), Cycloolefinpolymer (COP) oder Polyallyldiglycolcarbonat umfasst.

3. Beschichteter Gegenstand gemäß irgendeinem der Anspruch 1 oder 2, wobei die erste Beschichtungsschicht (a) aus einer Sol-Gel-Zusammensetzung gebildet ist, enthaltend:
(1) eine Harzkomponente enthaltend:
(i) Tetraalkoxysilan,
(ii) ein epoxyfunktionelles Trialkoxysilan,
(iii) einen metallhaltigen Katalysator und
(iv) eine Lösungsmittelkomponente, und
(2) eine partikelförmige Komponente enthaltend Titanoxid oder Zirconiumoxid, die in der Sol-Gel-Zusammensetzung in einer Menge von 20 bis 70 Gew.-%, bezogen auf das Gesamtgewicht der Feststoffe in der Sol-Gel-Zusammensetzung, die zur Bildung der ersten Beschichtungsschicht (a) eingesetzt wird, vorhanden ist.

4. Beschichteter Gegenstand gemäß irgendeinem der Ansprüche 1 bis 3, wobei die zweite Beschichtungsschicht (b) aus einer Sol-Gel-Zusammensetzung gebildet ist, enthaltend:
(1) eine Harzkomponente enthaltend:
(i) Tetraalkoxysilan,
(ii) ein epoxyfunktionelles Trialkoxysilan,
(iii) einen metallhaltigen Katalysator und
(iv) eine Lösungsmittelkomponente, und
(2) eine partikelförmige Komponente enthaltend Titanoxid oder Zirconiumoxid, die in der Sol-Gel-Zusammensetzung in einer Menge von 40 bis 95 Gew.-%, bezogen auf das Gesamtgewicht der Feststoffe in der Sol-Gel-Zusammensetzung, die zur Bildung der zweiten Beschichtungsschicht (C) eingesetzt wird, vorhanden ist

5. Der beschichtete Gegenstand gemäß irgendeinem der Ansprüche 1 bis 4, wobei die dritte Beschichtungsschicht (c) aus einer sauren Sol-Gel-Zusammensetzung gebildet ist, enthaltend:
(i) Tetraalkoxysilan,
(ii) Alkyltrialkoxysilan,
(iii) ein silanfunktionelles Acrylpolymer,
(iv) anorganische Oxidteilchen
(v) eine mineralische Säure
(vi) Wasser und
(vii) ein Lösungsmittel.

6. Der beschichtete Gegenstand gemäß irgendeinem der Ansprüche 1 bis 5, wobei das Substrat zwei sich gegenüberliegende Oberflächen aufweist.

7. Der beschichtete Gegenstand gemäß irgendeinem der Ansprüche 1 bis 6, wobei der beschichtete Gegenstand ein optischer Gegenstand ist, der ein Display-Element, ein Fenster, einen Spiegel und/oder ein aktives und passives Flüssigkristallzellen-Element oder eine aktive und passive Flüssigkristallzellen-Vorrichtung umfasst.

8. Ein Verfahren zur Herstellung eines beschichteten optischen Gegenstands, der antireflektierende Eigenschaften aufweist, umfassend:
(A) Aufbringen einer ersten Sol-Gel-Zusammensetzung auf zumindest eine Oberfläche eines Substrats, um eine erste Beschichtungsschicht zu bilden, wobei die erste Sol-Gel-Zusammensetzung zumindest ein Silan enthält und wobei die erste Beschichtungsschicht eine Trockenfilmdicke von 44 bis 64 nm und einen Brechungsindex von 1,62 bis 1,85 aufweist,
(B) Aufbringen einer zweiten Sol-Gel-Zusammensetzung auf zumindest eine Oberfläche der ersten Beschichtungsschicht, um eine zweite Beschichtungsschicht zu bilden, wobei die zweite Sol-Gel-Zusammensetzung ein Silan enthält und wobei die zweite Beschichtungsschicht eine Trockenfilmdicke von 70 bis 90 nm und einen Brechungsindex von 1,90 bis 2,10 aufweist,
(C) Aufbringen einer sauren Sol-Gel-Zusammensetzung auf zumindest eine Oberfläche der zweiten Beschichtungsschicht, um eine dritte Beschichtungsschicht zu bilden, wobei die saure Sol-Gel-Zusammensetzung ein Silan enthält und wobei die dritte Beschichtungsschicht eine Trockenfilmdicke von 74 bis 94 nm und einen Brechungsindex von 1,40 bis 1,48 aufweist, und
(D) Aufbringen einer bewuchshemmenden Schicht auf die dritte Beschichtungsschicht.

9. Das Verfahren gemäß Anspruch 8, wobei jede Beschichtung unabhängig voneinander mittels eines Schlitzdüsenbeschichtungsverfahrens, eines Sprühbeschichtungsverfahrens, eines Rotationsbeschichtungsverfahrens oder eines Tauchbeschichtungsverfahrens aufgebracht wird.

## Revendications

1. Article optique revêtu comprenant :
(A) un substrat ;
(B) un revêtement antireflet multicouche comprenant :
(a) une première couche de revêtement appliquée sur au moins une surface du substrat ; la première couche de revêtement ayant une épaisseur de feuil sec de 44 à 64 nm, et étant formée à partir d'une composition sol-gel comprenant un silane et la première couche de revêtement présentant un indice de réfraction de 1,62 à 1,85 ;
(b) une deuxième couche de revêtement appliquée sur au moins une surface de la première couche de revêtement ; la deuxième couche de revêtement ayant une épaisseur de feuil sec de 70 à 90 nm, et étant formée à partir d'une composition sol-gel comprenant un silane et la deuxième couche de revêtement présentant un indice de réfraction de 1,90 à 2,10 ;
(c) une troisième couche de revêtement appliquée sur au moins une surface de la deuxième couche de revêtement ; la troisième couche de revêtement ayant une épaisseur de feuil sec de 74 à 94 nm, et étant formée à partir d'une composition sol-gel acide comprenant un silane et la troisième couche de revêtement présentant un indice de réfraction de 1,40 à 1,48 ; et
(C) une couche de revêtement antisalissure appliquée sur au moins une surface de la troisième couche de revêtement.

2. Article revêtu selon la revendication 1, dans lequel le substrat (A) comprend du verre, du poly(méthacrylate de méthyle), du polycarbonate, du poly(éthylène téréphtalate) (PET), du poly(urée-uréthane), du polyamide, du triacétate de cellulose (TAC), un polymère de cyclo-oléfine (COP) ou du poly(carbonate d'allyldiglycol).

3. Article revêtu selon l'une quelconque des revendications 1 ou 2, dans lequel la première couche de revêtement (a) est formée à partir d'une composition sol-gel comprenant :
(1) un composant de type résine comprenant :
(i) du tétraalcoxysilane ;
(ii) un trialcoxysilane à fonction époxydique ;
(iii) un catalyseur contenant du métal ; et
(iv) un composant solvant ; et
(2) un composant particulaire comprenant de l'oxyde de titane ou de l'oxyde de zirconium, présent dans la composition sol-gel en une quantité de 20 à 70 pour cent en poids, par rapport au poids total de solides dans la composition sol-gel utilisée pour former la première couche de revêtement (a).

4. Article revêtu selon l'une quelconque des revendications 1 à 3, dans lequel la deuxième couche de revêtement (b) est formée à partir d'une composition sol-gel comprenant :
(1) un composant de type résine comprenant :
(i) du tétraalcoxysilane ;
(ii) un trialcoxysilane à fonction époxydique ;
(iii) un catalyseur contenant du métal ; et
(iv) un composant solvant ; et
(2) un composant particulaire comprenant de l'oxyde de titane ou de l'oxyde de zirconium, présent dans la composition sol-gel en une quantité de 40 à 95 pour cent en poids, par rapport au poids total de solides dans la composition sol-gel utilisée pour former la deuxième couche de revêtement (C).

5. Article revêtu selon l'une quelconque des revendications 1 à 4, dans lequel la troisième couche de revêtement (c) est formée à partir d'une composition sol-gel acide comprenant :
(i) du tétraalcoxysilane ;
(ii) de l'alkyltrialcoxysilane ;
(iii) un polymère acrylique à fonction silane ;
(iv) des particules d'oxyde inorganique ;
(v) un acide minéral ;
(vi) de l'eau ; et
(vii) un solvant.

6. Article revêtu selon l'une quelconque des revendications 1 à 5, dans lequel le substrat a deux surfaces opposées.

7. Article revêtu selon l'une quelconque des revendications 1 à 6, dans lequel ledit article optique revêtu est un article d'optique comprenant un élément d'affichage, une fenêtre, un miroir, et/ou un dispositif ou élément cellulaire à cristaux liquides actifs et passifs.

8. Procédé de formation d'un article optique revêtu qui présente des propriétés antireflet, comprenant les étapes consistant à :
(A) appliquer une première composition sol-gel sur au moins une surface d'un substrat pour former une première couche de revêtement, la première composition sol-gel comprenant au moins un silane et la première couche de revêtement ayant une épaisseur de feuil sec de 44 à 64 nm, et présentant un indice de réfraction de 1,62 à 1,85 ;
(B) appliquer une deuxième composition sol-gel sur au moins une surface de la première couche de revêtement pour former une deuxième couche de revêtement ; la deuxième composition sol-gel comprenant un silane et la deuxième couche de revêtement ayant une épaisseur de feuil sec de 70 à 90 nm, et présentant un indice de réfraction de 1,90 à 2,10 ;
(C) appliquer une composition sol-gel acide sur au moins une surface de la deuxième couche de revêtement pour former une troisième couche de revêtement, la composition sol-gel acide comprenant un silane et la troisième couche de revêtement ayant une épaisseur de feuil sec de 74 à 94 nm, et présentant un indice de réfraction de 1,40 à 1,48 ; et
(D) appliquer une couche de revêtement antisalissure sur la troisième couche de revêtement.

9. Procédé selon la revendication 8, dans lequel chaque revêtement est appliqué indépendamment par un procédé d'enduction à la filière plate, un procédé d'enduction par pulvérisation, un procédé d'enduction par centrifugation, ou un procédé d'enduction par immersion.
